# EUROPEAN PATENT SPECIFICATION

(11) **EP 3 288 187 B1**
(45) Date of publication and mention of the grant of the patent: **04.01.2023**
(21) Application number: 17189357.1
(22) Date of filing: 30.11.2012
(51) Int. Cl.: H03M 13/35, H04L 1/00, H04N 19/66, H03M 13/15, H03M 13/37, H03M 13/11, H04L 65/80, H04N 21/2383, H04L 65/70

(54) **APPARATUS AND METHOD FOR TRANSMITING LAYERED SOURCE DATA**
VORRICHTUNG UND VERFAHREN ZUM SENDEN VON GESCHICHTETEN QUELLDATEN
APPAREIL ET PROCÉDÉ POUR TRANSMISSION DE DONNÉES SOURCES MULTICOUCHES

(30) Priority: 30.11.2011 KR 20110127366
(43) Date of publication of application: 28.02.2018
(62) Divisional of application: 12853877.4
(73) Proprietor: Samsung Electronics Co., Ltd., Gyeonggi-do 16677 (KR)
(72) Inventor: Hwang, Sung Hee, 16677 Suwon-si (KR); Park, Kyung-Mo, 16677 Suwon-si (KR); Yang, Hyun-Koo, 16677 Suwon-si (KR); Hwang, Sung-Oh, 16677 Suwon-si (KR); Rhyu, Sung-Ryeul, 16677 Suwon-si (KR)
(74) Representative: Nederlandsch Octrooibureau

(56) References cited:
- SHERWOOD P G ET AL: "Error protection for progressive image transmission over memoryless and fading channels", IMAGE PROCESSING, 1998. ICIP 98. PROCEEDINGS. 1998 INTERNATIONAL CONFERENCE ON CHICAGO, IL, USA 4-7 OCT. 1998, LOS ALAMITOS, CA, USA,IEEE COMPUT. SOC, US, vol. 1, 4 October 1998 (1998-10-04), pages 324-328, XP010308741, DOI: 10.1109/ICIP.1998.723484 ISBN: 978-0-8186-8821-8
- BOULGOURIS N V ET AL: "Wireless Image Transmission Using Turbo Codes and Optimal Unequal Error Protection", IEEE TRANSACTIONS ON IMAGE PROCESSING, IEEE SERVICE CENTER, PISCATAWAY, NJ, US, vol. 14, no. 11, November 2005 (2005-11), pages 1890-1901, XP011140384, ISSN: 1057-7149, DOI: 10.1109/TIP.2005.854482
- JOACHIM HAGENAUER ET AL: "Channel Coding and Transmission Aspects for Wireless Multimedia", PROCEEDINGS OF THE IEEE, IEEE. NEW YORK, US, vol. 87, no. 10, October 1999 (1999-10), XP011044279, ISSN: 0018-9219
- MARTINI M G ET AL: "ROBUST TRANSMISSION OF MPEG-4 VIDEO: START CODES SUBSTITUTION AND LENGTH FIELD INSERTION ASSISTED UNEQUAL ERROR PROTECTION", PROCEEDINGS OF THE PICTURE CODING SYMPOSIUM, XX, XX, 25 April 2001 (2001-04-25), pages 155-158, XP001150368,
- SHENGJIE ZHAO ET AL: "Optimal Resource Allocation for Wireless Video over CDMA Networks", IEEE TRANSACTIONS ON MOBILE COMPUTING, IEEE SERVICE CENTER, LOS ALAMITOS, CA, US, vol. 4, no. 1, January 2005 (2005-01), pages 56-67, XP011123479, ISSN: 1536-1233, DOI: 10.1109/TMC.2005.13
- HELLGE C ET AL: "Layer-Aware Forward Error Correction for Mobile Broadcast of Layered Media", IEEE TRANSACTIONS ON MULTIMEDIA, IEEE SERVICE CENTER, US, vol. 13, no. 3, 1 June 2011 (2011-06-01), pages 551-562, XP011479795, ISSN: 1520-9210, DOI: 10.1109/TMM.2011.2129499

## Description

### [Technical Field]

The present invention relates generally to an apparatus and method of transmitting and/or receiving broadcast data. More particularly, the present invention relates to an apparatus and method of transmitting/receiving broadcast data based on encoding and decoding technologies.

### [Background Art]

Typically, in a broadcast network, multimedia content is communicated with Moving Picture Experts Group-2 Transport Streams (MPEG-2 TS). Especially, it is desirable to use the MPEG-2 TS in transmitting bitstreams into which a plurality of broadcast programs are multiplexed in erroneous transmit environments. For example, MPEG-2 TS is suitable to use in broadcast services for Digital Televisions (DTVs).

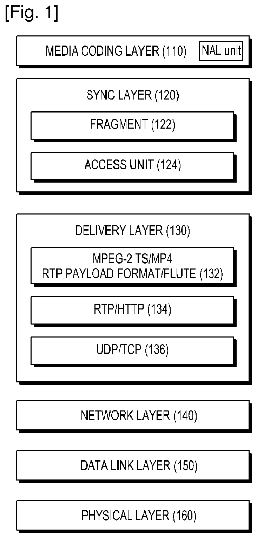

Cornelius Hellge, David Gomez-Barquero, Thomas Schierl, and Thomas Wiegand: Layer-Aware Forward Error Correction for Mobile Broadcast of Layered Media, IEEE Transactions on Multimedia, vol. 13, pp. 551-562, 2011 discloses an unequal error protection forward error correction, UEP-FEC, coding method for layered video such as Scalable or Multiview Video Coding, SVC or MVC, in a backwards-compatible way.FIG. 1 depicts a hierarchical structure for supporting the MPEG-2 TS according to the related art.

Referring to FIG. 1, the hierarchical structure for supporting the MPEG-2 TS consists of a media coding layer 110, a sync layer 120, a delivery layer 130, a network layer 140, a data link layer 150, and a physical layer 160. The media coding layer 110 and the sync layer 120 configure media data in a format to be used as basic units for recording and transmission. The delivery layer 130, the network layer 140, the data link layer 150, and the physical layer 160 configure data blocks in the format configured in the sync layer 120 so as to be multimedia frames for recording in a separate recording medium or transmission. The multimedia frames are transmitted to a subscriber's terminal via a predetermined network.

The sync layer 120 includes a fragment block 122 and an access unit 124, and the delivery layer 130 includes MPEG-2 TS/ Moving Picture Experts Group-4 (MP4) unit 132, Real-time Transport Protocol/Hypertext Transfer Protocol (RTP/HTTP) unit 134, and User Datagram Protocol/Transmission Control Protocol unit (UDP/TCP) 136.

However, the MPEG-2 TS has several constrains on supporting multimedia services, such as unidirectional communication, transmission inefficiency due to fixed frame size, and unnecessary overhead occurrence when a transfer protocol dedicated to audio/video and the Internet protocol (IP) are used for transmission. Thus, MPEG has newly proposed an MPEG Media Transport (MMT) standard as one of the multimedia transfer technologies for providing MPEG-based multimedia services. The MMT standard has been proposed to address the constraints of the MPEG-2 TS.

For example, the MMT standard can be applied to support efficient hybrid contents delivery services over heterogeneous networks. The hybrid content delivery service refers to a service of offering contents having hybrid multimedia elements, such as video, audio, applications, and other similar and/or suitable elements. The heterogeneous network refers to a network in which a broadcasting network and a communication network are mixed. Furthermore, the MMT standard aims at defining a more IP-friendly transfer technology, the IP having been considered a basic technology in a transfer network for multimedia services.

Therefore, the MMT standard for providing an efficient MPEG transfer technology in a representative IP-based changing multimedia service environment is in progress of standardization with ongoing research. The MMT standard uses a preparation for a scheme to provide the efficient MPEG transfer technology in recent multimedia service environments of attempting to provide hybrid networks and hybrid content transfer services. On the other hand, an MMT system provides high-capacity content, such as High Definition (HD) content, Ultrahigh High Definition (UHD) content, or other similar and/or suitable content, in various ways.

In the MMT system, as the content gets more diversified and has higher capacity, data congestion becomes serious. This leads to a failure to deliver content data transmitted by a transmitter to a receiver, and thus to a situation in which all or a part of the transmitted content data is missing during transmission without arriving at the receiver. In general, data is transmitted in packets and so that data loss occurs in a unit of a packet. The packet loss that may occurr in the MMT system causes various problems, such as degradation of audio quality, degradation of video quality or break in screen, subtitle omission, file loss, and other similar problems. Thus, the MMT system employs an error-control technology to reduce the information or data loss that may be possibly caused due to network congestion depending on channel conditions. A representative example of the error-control technology is an Application Layer-Forward Error Correction (AL-FEC) scheme.

However, in order to apply the AL-FEC scheme in the MMT system that supports the hybrid content delivery service, different types of contents for the hybrid content delivery service should meet different Quality of Service (QoS) requirements. For example, audio and video data uses QoS that allows partial loss but the least delay. On the contrary, file data uses QoS that allows a little delay but the least loss. For example, for Scalable Video Coding (SVC), content corresponding to a base layer, which may be relatively more important than content corresponding to an enhanced layer, should have protection based on relatively stronger encoding. The same is the case for Multi-View Coding (MVC). In other words, in a case of 3-Dimensional (3D) content, a left view is considered the base layer and a right view is considered the enhanced layer, and so the left view, which is the base layer, uses stronger protection. Thus, an AL-FEC technology should efficiently protect a plurality of contents that have different QoS requirements in the MMT system supporting the hybrid content delivery service.

The above information is presented as background information only to assist with an understanding of the present disclosure. No determination has been made, and no assertion is made, as to whether any of the above might be applicable as prior art with regard to the present invention.

### [Disclosure]

### [Technical Problem]

Aspects of the present invention are to address at least the above-mentioned problems and/or disadvantages and to provide at least the advantages described below. Accordingly, an aspect of the present invention may be to provide an apparatus and method of encoding and decoding a source block including different kinds of data having different Quality of Service (QoS) requirements, in consideration of the QoS.

Another aspect of the present invention may be to provide an encoding apparatus and method of determining a two-stage FEC encoding scheme to be applied in encoding a source block including different kinds of data that have different QoS requirements in two stages according to the types of data segments that make up the source block.

Another aspect of the present invention may be to provide an encoding apparatus and method of configuring coded signal information in encoding a source block including different kinds of data having different QoS requirements in two stages.

Another aspect of the present invention may be to provide an encoding apparatus and method of having coded signal information contain information for identifying what is subject to extended encoding when encoding a source block made up of different kinds of data having different QoS requirements in two stages.

Another aspect of the present invention may be to provide a flag for identifying whether an object to be subject to extended encoding is an entire source block made up of different kinds of data having different QoS requirements or a particular type of data segments within the source block when encoding the source block in two stages.

Another aspect of the present invention may be to provide a scheme for including position information of payloads within a source coded block resulting from a two-stage encoding of a source block made up of different kinds of data having different QoS requirements in a coded signal information when encoding the source block in two stages.

### [Technical Solution]

This object and other objects which will become apparent from the following description are achieved at least in part by a method or a coding apparatus for encoding a source block including layered media data with a base layer and an enhanced layer according to the independent claims. Embodiments are defined by the dependent claims. [Description of Drawings]

The above and other aspects, features, and advantages of certain exemplary embodiments of the present invention will be more apparent from the following description taken in conjunction with the accompanying drawings, in which:
FIG. 1 shows a hierarchical structure for supporting the MPEG-2 TS according to the related art;
FIGs. 2A and 2B show structures of a source coded block (or Forward Error Correction (FEC) block) generated in an encoding apparatus according which is not part of the present invention.
FIG. 3 shows a full two-stage FEC encoding scheme according to an exemplary embodiment of the present invention;
FIG. 4 shows a partial two-stage FEC encoding scheme, according to an exemplary embodiment of the present invention;
FIGs. 5 to 7 show types of data segments that make up a source block, according to an exemplary embodiment of the present invention;
FIG. 8 shows a transfer of coded signal information using in-band signaling, according to an exemplary embodiment of the present invention;
FIG. 9 is a structure of a source packet that makes up a source part of a sub coded block for transferring the coded signal information using in-band signaling, according to an exemplary embodiment of the present invention;
FIG. 10 is a structure of a parity packet that makes up a parity part of a sub coded block for transferring the coded signal information using in-band signaling, according to an exemplary embodiment of the present invention;
FIG. 11 is a structure of an MMT header of an MPEG Media Transport (MMT) packet that corresponds to the source packet of FIG. 9 or the parity packet of FIG. 10, according to an exemplary embodiment of the present invention;
FIGs. 12A to 12D show structures of an FEC In-band signals of the MMT packet that corresponds to the source packet of FIG. 9 or the parity packet of FIG. 10, according to an exemplary embodiment of the present invention;
FIGs. 13A and 13B show implementations of the partial two-stage FEC encoding scheme with in-band signaling, according to an exemplary embodiment of the present invention;
FIG. 14 shows a block diagram of an apparatus for transmitting the coded signal information using out-band signaling, according to an exemplary embodiment of the present invention; and
FIG. 15 shows a block diagram of an apparatus for transmitting the coded signal information using in-band signaling, according to an exemplary embodiment of the present invention.

Throughout the drawings, it should be noted that like reference numbers are used to depict the same or similar elements, features, and structures.

### [Mode for Invention]

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

In the following description, terms to be used in the detailed description of the exemplary embodiments of the present invention are defined below for convenience of explanation. A source Block is a set of different types of data segments having different QoS requirements for a hybrid content delivery service. A sub block is a data block including different types of data segments having different QoS requirements, which is obtained by dividing the source bock by M (M is an integer equal to or greater than 1). A data segment is a unit set of data to be recorded in a predetermined size into the source block or the sub block. A Forward Error Correction (FFC) code is a code used for FEC encoding, which is an error correction code for correcting an error or erasure symbol. There may be various codes, such as an RS code, an LDPC, a Raptor code, a Raptor Q code, an XOR code, etc. used as the FEC code. A FFC Coding is encoding to be performed on the source block, sub block, or a particular type of data segments that reside in the source block with the FEC code.

Furthermore, a two stage FEC coding is an encoding scheme by which the sub block is subject to a first FEC coding with a first FEC code, and the source block or a particular type of data segments that reside in the source block is subject to a second FEC encoding. A sub coded block or FEC frame is a codeword generated by the first FEC encoding of the sub block, which is comprised of a target sub block (i.e., a source part) to be subject to the first FEC encoding and a parity part obtained from the first FEC encoding of the target sub block. For convenience of explanation, it is generally termed as the sub coded block. A source part is a target sub block to be subject to the first FEC encoding, and a set of a predetermined number (K, an integer equal to or greater than 1) of source payloads (or source packets) that make up the sub coded block. Thus, the predetermined number (K) of source payloads may be equal to data segments that make up the target sub block. A parity part (or repair part) is a set of a predetermined number of parity payloads (or a set of parity packets) obtained for error correction from the FEC encoding of given data.

Also, a base parity part (or base repair part) is a set of a predetermined number (P1, an integer equal to or greater than 1) of parity payloads (or parity packets) that make up the sub encoded block, which are obtained from the first FEC encoding of the target sub block. An extended parity part (or extended repair part) is a set of a predetermined number (P2, an integer equal to or greater than 1) of parity payloads (or parity packets) obtained from the second FEC encoding of the entire source block or a particular type of data segments that reside in the source block. A source coded block or FEC block is a coded block including sub coded blocks obtained from the first FEC encoding of the sub blocks and the extended parity part obtained from the second FEC encoding of the entire source block or a particular type of data segments of the source block. A source coded packet or FEC packet is a packet including header information and the source coded block. In case of using in-band signaling, the header information contains coded signal information corresponding to a source coded block or an FEC block. A coded signal information or FEC control information is control information referred to for reconstructing the source coded block or to control the source coded packet or the FEC packet. It includes configuration information based on the two-stage FEC encoding, i.e., first FEC configuration information and second FEC configuration information.

Additionally, a coded signal packet or FEC control packet is a packet in which to transmit the coded signal information or FEC control information, in case of using out-band signaling. A symbol is a data unit in the source block, sub block, source coded block, or sub coded block. A- source symbol is a data symbol that makes up the source block or sub block before FEC encoding. A coded symbol is a symbol generated by performing the first or second FEC encoding on the source symbol, which is a data symbol that makes up the source coded block or sub coded block;- systematic symbol or information symbol: one of coded symbols that belongs to the source part. A parity symbol or repair symbol is one of coded symbols that belongs to the parity part or repair part. A base parity symbol or base repair symbol is one of coded symbols that belongs to the base parity part or base repair part; and an extended parity symbol or extended repair symbol is one of coded symbols that belongs to the extended parity part or extended repair part.

In following exemplary embodiments of the present invention, the coded signal information, which is also referred to as FEC control information, regarding the two-stage encoding of the source block may include different kinds of data having different QoS requirements is newly defined. The newly defined coded signal information refers to control information to be used for reconstructing a source block encoded with the two-stage FEC encoding scheme. For example, the coded signal information may be defined, corresponding to the two-stage FEC encoding scheme used for encoding of the source block. This will be described below in more detail. On the other hand, an exemplary embodiment of the present invention proposes a scheme for providing the coded signal information for an apparatus, such as a decoding apparatus, for reconstructing the coded block generated by the two-stage encoding.

The present invention proposes that a full two-stage encoding scheme and a partial two-stage encoding scheme are selectively used for the two-stage encoding.

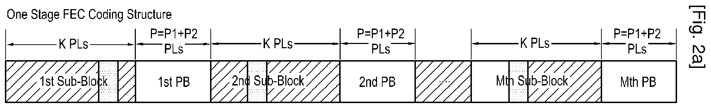

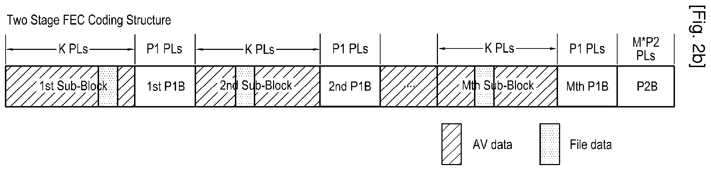

FIGs. 2A and 2B show structures of a source coded block (or FEC block) generated in an encoding apparatus, which are not part of the present invention.

FIG. 2A shows a structure of the source coded block generated by one-stage FEC encoding of the source block, i.e., one stage FEC coding structure.

Referring to FIG. 2A, the source block is divided into M sub blocks, each of which has a predetermined size. Each of the M sub blocks is FEC encoded with FEC codes. In the FEC encoding, K source Payloads (K PLs) and P parity Payloads (P PLs) are generated, corresponding to each of M sub blocks.

The sub block is assumed to have different types of data segments that require different Quality of Service (QoS). The data segment is configured with data corresponding to an asset of a same kind, or configured by multiplexing data corresponding to different kinds of assets. Here, the different kinds of assets may include audio, video, file assets, and the like.

Referring to FIG. 2A, shaded sections indicate Audio and Video (AV) source payloads, i.e. AV data, corresponding to audio and video assets that require the same QoS. Dotted sections indicate file data source payloads, i.e. file data, corresponding to file assets that require different QoS. In addition, white sections indicate parity payloads. P parity payloads are comprised of P1 parity symbols generated by FEC encoding of audio and video data segments and P2 parity symbols generated by FEC encoding of file data segments.

Accordingly, a sub coded block obtained from FEC encoding of a sub block is comprised of source and parity parts. The source part includes K source payloads, and the parity part includes P parity payloads. As an example, the K source payloads consist of source payloads that correspond to audio, video, and file data segments. The P parity payloads consist of P1 parity payloads generated by FEC encoding of audio data segments and video data segments and P2 parity payloads generated by FEC encoding of file data segments.

FIG. 2B shows a structure of the source coded block generated by two-stage FEC encoding of the source block, i.e., two stage FEC encoding structure.

Referring to FIG. 2B, the source block is divided into M sub blocks, each of which has a predetermined size. M sub coded blocks are generated by performing the first FEC encoding on each of M sub blocks. Each of the M sub coded blocks includes K PLs and P1 parity Payloads (PI PLs). Second FEC encoding is performed on the entire source block or data segments of a particular type, i.e. particular assets, that reside in the source block. By the second FEC encoding, P2 extended parity payloads, such as P2B, M^{∗}P2 PLs, are generated.

Accordingly, each of sub coded blocks obtained from the first FEC encoding is comprised of a source part and a base parity part. The source part includes K source payloads. The base parity part includes P1 parity loads. As an example, the K source payloads included in the source part correspond to the audio, video, or file data segment. P1 parity payloads included in the base parity part are generated by the first FEC encoding of the audio, video, or file data segment.

Referring to FIG. 2B, shaded sections indicate audio and video source payloads, i.e. AV data, corresponding to audio and video assets that have the same QoS requirement. Dotted sections indicate file data source payloads, i.e. file data, corresponding to a file asset that requires different QoS. In addition, white sections indicate parity payloads. The second FEC encoding is performed on all data segments in the source block or a particular type of data segments in the source block, such as file data segments. P2 extended parity payloads generated by the second FEC encoding make up the extended parity part. Thus, the source coded block is made up by combining sub coded blocks generated by the first FEC encoding and the extended parity part generated by the second FEC encoding.

In the foregoing description, for a hybrid content delivery service, such as AV streaming with files, two cases were examined, a first case where each sub block further includes parity symbols, such as P1+P2 FEC parities, in one stage, as in FIG. 2A, and a second case where extended parity symbols, such as M^{∗}P2 FEC parities, are added to the entire M sub blocks, as in FIG. 2B. In the hybrid content delivery service, AV data and file data are transmitted together. The file data demands better FEC performance than that of the AV data. Thus, in comparison with transmission of only AV data, transmission of the AV data together with the file data further requires an FEC parity, i.e., an extended parity symbol.

Typically, a better AV streaming service has a less delay. In order to have the less delay in the AV streaming service, FEC encoding has to be performed with as short a block as possible, such as a short FEC code. On the contrary, the file data is not significantly affected by the delay, but requires high FEC performance. Accordingly, the file data should be FEC encoded with as long a block as possible, such as a long FEC code. This is because, by the nature of FEC encoding, long blocks shows better FEC performance than short blocks in case of applying the same parity addition rate.

Thus, the hybrid content delivery service that needs to transfer AV data and file data together in the same stream requires an FEC encoding technology to guarantee less delay for the AV data and high FEC performance for the file data. An example which is not part of the present invention is based on the two stage FEC coding structure in which the AV data is protected with a short block while the file data is protected with a long block.

In the two-stage FEC coding structure, an extended parity, such as P2 parities, for an asset demanding relatively high FEC performance is additionally assigned. In an example of the two-stage FEC coding, an AV asset that demands less delay is FEC encoded with a short block, and a file data that demands good FEC performance is FEC encoded with a long block. On the other hand, two implementations of the two-stage FEC coding are provided as exemplary embodiments based on what is subject to the second FEC encoding performed in addition to the first FEC encoding. A first implementation has an entire source block be subject to the second FEC encoding. A second implementation has a particular type of data segments that has a QoS requirement that meets a criterion in the source block be subject to the second FEC encoding. The first implementation may be an option 1, which may be referred to as a full two-stage FEC encoding scheme, and the second implementation may be an option 2, which may be referred to as a partial two-stage FEC encoding scheme.

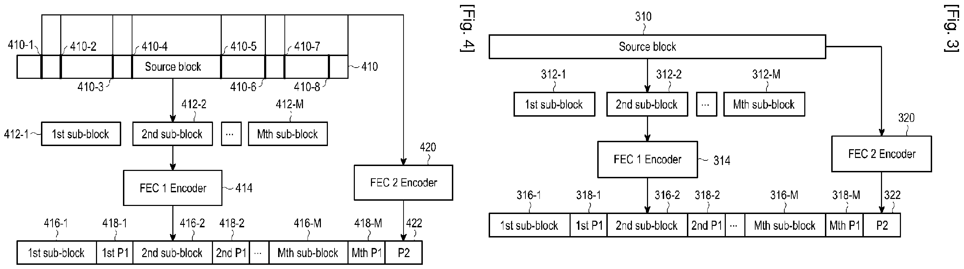

FIG. 3 shows a full two-stage FEC encoding scheme according to an exemplary embodiment of the present invention;

Referring to FIG. 3, a source block 310 is divided into M sub blocks 312-1, 312-2,..., 312-M. The M sub blocks 312-1, 312-2,..., 312-M each go through the first FEC encoding (FEC 1 Encoding) 314. M sub coded blocks are generated by the first FEC encoding 314 corresponding to M sub blocks 312-1, 312-2,..., 312-M, respectively. Each of the M sub coded blocks includes a source part 316-1, 316-2, ..., 316-M and a parity part 318-1, 318-2,..., 318-M. As the source part 316-1, 316-2,..., 316-M has the same symbols as those of the corresponding sub block, they are represented with the same terms in the figure. The parity part 318-1, 318-2,..., 318-M has parity symbols obtained by performing the first FEC encoding on the corresponding sub block.

On the other hand, the source block 310 goes through second FEC encoding (FEC 2 Encoding) 320. Extended parity symbols are obtained from the second FEC encoding 320. The obtained extended parity symbols constitute an extended parity part P2 322. Thus, the source coded block is made up by combining M sub coded blocks obtained from the first FEC encoding 314 and the extended parity part 322 obtained from the second FEC encoding 320.

As described above, in the full two-stage FEC encoding, the entire source block is subject to the first FEC encoding and the second FEC encoding. In other words, the first FEC encoding is performed with a first FEC code on each of the sub blocks divided from the source block to generate a base parity part including a predetermined number P1 of parity payloads. The second FEC encoding is performed with a second FEC code on the entire source block to generate an extended parity part including a predetermined number P2 of parity payloads.

FIG. 4 shows a partial two-stage FEC encoding scheme according to an exemplary embodiment of the present invention.

Referring to FIG. 4, a source block 410 is divided into M sub blocks 412-1, 412-2,..., 412-M. The M sub blocks 412-1, 412-2,..., 412-M each go through first FEC encoding (FEC 1 Encoding) 414. M sub coded blocks are generated by the first FEC encoding 414 that correspond to M sub blocks 412-1, 412-2,... , 412-M, respectively. Each of the M sub coded blocks is includes a source part 416-1, 416-2, ..., 416-M and a parity part 418-1, 418-2, ..., 418-M. The source part 416-1, 416-2, ..., 416-M has the same symbols as those of the corresponding sub block, and thus the same terms are represented in the figure. Parity symbols obtained from the first FEC encoding of the sub block constitute the parity part 418-1, 418-2, ..., 418-M.

On the other hand, data segments 410-1, 410-2, 410-3, 410-4, 410-5, 410-6, 410-7, 410-8 of a type that meets a predetermined condition from among different types of data segments that make up the source block 410 is subject to second FEC encoding (FEC 2 Encoding) 420. The second FEC encoding 420 generates extended parity symbols. The generated extended parity symbols constitutes an extended parity part, such as an extended parity block, P2 422. The source coded block is made up by combining M sub coded blocks obtained from the first FEC encoding 414 and the extended parity part 422 obtained from the second FEC encoding 420.

Meanwhile, for the two-stage FEC encoding proposed in FIG. 4, a type of data segments to be subject to the second FEC encoding has to be determined. Thus, a criterion for determining the type of data segments to be subject to the second FEC encoding needs to be set in advance. It is desirable to set the criterion by using QoS requirements for different types of data segments that make up sub block. For example, the criterion may be set by selecting a type of data segments that requires the highest QoS among different types of data segments that make up the sub block. If the sub block includes an audio data segment, a video data segment, and a file data segment, one of those data segments that should have the highest QoS satisfies the criterion. Use of the highest QoS implies a need for the highest FEC performance. The invention is however limited to the data segments which should have the highest QoS requirements being segments containing base layer data.

In general cases which are not all part of the invention, QoS needed for each type of the data segment is determined based on an extent of transmission loss, priority, error recovery performance, transfer scheme, and/or data type. That is, a type of the data segment demanding a little extent of transmission loss, high priority, and/or high level of error recovery performance requires relatively high QoS. Besides, a data segment using non-timed transmission requires relatively high QoS compared to that using timed transmission. Furthermore, the data segment corresponding to left-view for supporting 3D image needs relatively high QoS compared to that corresponding to right-view, and the data segment corresponding to I-frame needs relatively high QoS among those corresponding to I-frame, P-frame, B-frame.

Referring to FIG. 4, such is a case where the source block includes different types of data segments that require different QoS. In this regard, one type of data segment may include data corresponding to assets of one kind, or made up by multiplexing data corresponding different kinds of assets. The invention is however limited to the case where the kinds of asset are base and enhanced layer assets.

In a case where the data segments include data corresponding to assets of a kind, it is desirable to apply the partial two-stage FEC encoding as proposed in FIG. 4. Otherwise, in a case where the data segments are made up by multiplexing data corresponding to different kinds of assets, it is desirable to apply the full two-stage FEC encoding as proposed in FIG. 3.

Thus, keeping the foregoing in mind in the two-stage FEC encoding, it is essential to identify which types of data segments are included in the source block in order to selectively apply the full two-stage FEC encoding and the partial FEC encoding. For example, an MMT package defines a Transport Characteristic (TC) for each of MMT assets. The TC includes information about error recovery. That is, the error recovery information is one of the TC information. For example, the TC may include information about QoS, such as QoS information, needed for each asset. The QoS information may be defined based on the foregoing factors, such as an allowable extent of transmission loss, an allowable delay, and/or the like.

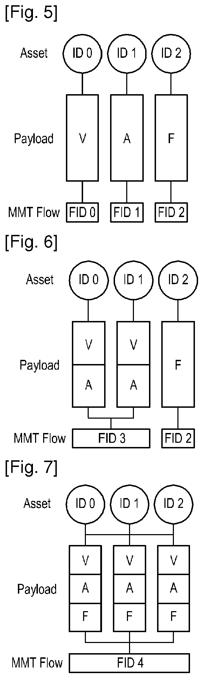

FIGs. 5 to 7 show types of data segments that make up the source block according to an exemplary embodiment of the present invention. Referring to FIGs. 5 to 7, data that makes up the source block includes a video asset, an audio asset, and a file asset, each of which is given unique identification information ID0, ID1, or ID2. The invention is however limited to the case where the kinds of asset are base and enhanced layer assets.

Referring to FIG. 5, data segments in the source block are shown, wherein the data segments corresponding to assets of one kind. That is, in FIG. 5, a video asset, an audio asset, and a file asset each given a unique identification information, which may be referred to as asset identification information, each corresponding to an independent data segment. Thus, a header of each data segment contains one piece of asset identification information.

Accordingly, in the two-stage FEC encoding, from the asset identification information recorded in the header of each data segment, which asset the data contained in the data segment is about may be identified. This enables identification of the data segment that corresponds to the file asset to be subject to the second FEC encoding from among data segments that make up the source block, and thus the partial two-stage FEC encoding is applied in the case of FIG. 5.

FIG. 6 shows data segments, some of which are made up by multiplexing data for different kinds of assets, such as a video asset and an audio asset, and the other of which includes data for an asset of one kind, such as a file asset. Asset identification information for the audio and video assets is recorded in the header of the data segment made up by the multiplexing, and asset identification information for file asset exists in the header of the data segment including one asset.

Accordingly, in the two-stage FEC encoding, from the asset identification information recorded in the header of each data segment, which asset the data contained in the data segment is about may be identified. In an example which is not part of the invention, this enables identification of a data segment that corresponds to a file asset to be subject to the second FEC encoding from among data segments that make up the source block, and thus the partial two-stage FEC encoding is applied in the case of FIG. 6.

FIG. 7 shows data segments each made up by multiplexing data for different kinds of assets. In examples which are not part of the invention, the assets include a video asset, an audio asset, and a file asset. That is, in FIG. 7, headers of all data segments each include asset identification information for the audio asset, video asset, and the file asset.

Thus, in the two-stage FEC encoding, it is difficult to extract data for a particular asset, e.g., the file asset, from the asset identification information recorded in the header of each data segment. In this case, it is impossible to distinguish data only for the file asset to be subject to the second FEC encoding from the source block, the full two-stage FEC encoding scheme is applied to the case of FIG. 7.

Table 1 shows an exemplary format of a data segment defined to determine which two-stage FEC encoding scheme is to be used. That is, Table 1 shows an example of providing QoS identification information in the header of a data segment.

**[Table 1]**

| |
|---|
| .... |
| QoS Indicator |
| .... |

In Table 1, a QoS Indicator is information that identifies priority, layer type, frame type, transmission type, FEC performance, data type, etc. For example, the QoS Indicator may be used to identify "High or Low Priority", "Base Layer or Enhanced Layer", "I-frame or not", "I-frame or other-frame", "Timed data or Non-timed data", "High or Low FEC Protection", "Left-view or Right-view", "AV data or File data", or the like. According to the invention, the QoS Indicator has information that identifies the "Base Layer Asset" and "Enhanced Layer Asset", so that a data segment for the base layer asset and a data segment for the enhanced layer asset may be distinguished. In this case, from the asset identification information recorded in the header of each data segment that makes up the source block, which asset the data segment is about may be recognized. Therefore, the partial FEC encoding is applied where only the data segment for the base layer asset may be subject to the second FEC encoding.

However, it is not true for a case in which a data segment is made up by multiplexing data for the base layer asset and data for enhanced layer asset. It is because asset identification information for the base layer asset and asset identification information for the enhanced layer asset exist together in the header of the data segment. Therefore, the full FEC encoding is applied because the second FEC encoding may not be performed only on the data segment for the base layer asset.

In another case which is not part of the invention, the QoS Indicator has information that identifies "I-frame" from "other-frame". In this case, a data segment for I-frame and a data segment for P-frame or B-frame may be separately configured. Thus, from identification information recorded in the header of each data segment that makes up the source block, which frame the data recorded in the payload is about may be recognized. The identification information may be information indicating whether the payload of the data segment contains data of I-frame or not.

Since the type of data contained in the payload of the data segment may be recognized from the identification information, the partial two-stage FEC encoding in which the second FEC encoding is performed on the data segment of a desired type among data segments that make up the source block may be possibly applicable. However, in a case of configuring a data segment by multiplexing data of the I-frame and data of other-frame, e.g., a P-frame or a B-frame, it is difficult to extract only the data segment that corresponds to the I-frame. Such is the case because asset identification information for the I-frame and asset identification information for the other-frame exist together in the header of the data segment that makes up the source block.

On the other hand, in order to correctly decode the source coded block generated by the two-stage FEC encoding according to the exemplary embodiment of the present invention, coded signal information should be newly defined. The coded signal information is derived from the two-stage FEC encoding used to generate the source coded block. The coded signal information should be configured by taking into account which one of the full FEC encoding and the partial FEC encoding was employed for the two-stage FEC encoding. In addition, it is desirable to configure the coded signal information by taking into account a transmission scheme of the coded signal information and a format to be used for the source payload as well. The transmission scheme of the coded signal information may be classified into in-band signaling and out-band signaling.

For example, FEC configuration information that makes up the coded signal information mainly includes at least one of length information and identification information. Furthermore, not only a combination of the first FEC code and the second FEC code but also a flag for identifying what is subject to the second FEC encoding may be added. For example, the flag enables identification of whether the full two-stage encoding, in which the entire source block was subject to the second FEC encoding was used, or the partial two-stage encoding, in which data segments of one type among different types of data segments were subject to the second FEC encoding, was used.

The length information includes at least one of information of source block length, information of sub block length, information of source part length, information of base parity part length, and information of extended parity part length. The length information may be information of the number of elements. In other words, the length information includes at least one of the number of data segments in the source block, the number of data segments in the sub block, the number K of source payloads in the source part, the number P1 of parity payloads in the base parity part, and the number P2 of parity payloads in the extended parity part.

The identification information includes at least of identification information of the source block, identification information of the sub block, identification information of the source part, identification information of the base parity part, identification information of the extended parity part, identification information of each source payload that resides in the source part, identification information of each parity payload that resides in the base parity part, identification information of each parity payload that resides in the extended parity part, and identification information of each data segment that makes up the sub block. In addition, there may be identification information of a coding unit block.

The identification information of the source payload may use a sequence number in ascending order or in descending order according to the position of the source payload within the source part. The identification information of the base parity payload may use a sequence number in ascending order or in descending order according to the position of the base parity payload within the base parity part. The identification information of the extended parity payload may use a sequence number in ascending order or in descending order according to the position of the extended parity payload within the extended parity part.

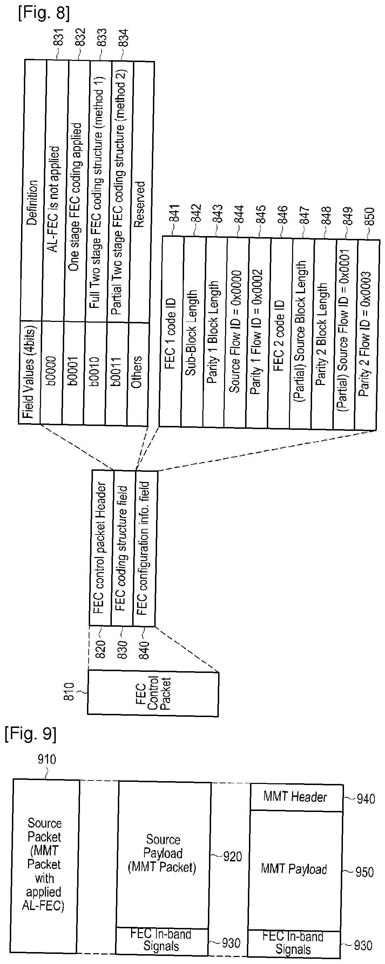

FIG. 8 shows an exemplary transmission of the coded signal information using in-band signaling, according to an exemplary embodiment of the present invention.

Referring to FIG. 8, a structure of the coded signal packet or FEC control packet for transmission of the coded signal information based on in-band signaling is shown. A FEC control packet 810 includes an FEC control packet header 820 and a payload. The payload includes an FEC coding structure field 830 and an FEC configuration info field 840.

The FEC control packet header 820 includes information identifying that it is an FEC control packet, and the FEC coding structure field 830 includes information that identifies which encoding scheme was used for the source coded packet being transmitted. For example, flag values recorded in the FEC coding structure field 830 are defined to distinguish cases of AL-FEC is not applied 831, One-stage FEC coding applied 832, Full Two-stage FEC coding structure (method 1) 833, and Partial Two-stage FEC coding structure (method 2) 834. That is, a flag value for AL-FEC is not applied 831 is defined to be 'b000', a flag value for One-stage FEC coding applied 832 is defined to be 'b001', a flag value for Full Two-stage FEC coding structure (method 1) 833 is defined to be 'b010', and a flag value for Partial Two-stage FEC coding structure (method 2) 834 is defined to be 'b011'.

The FEC configuration info field 840 includes control information regarding the two-stage FEC encoding. That is, the control information regarding the two-stage FEC encoding included in the FEC configuration info field 840 includes information about the first FEC encoding and information about the second FEC encoding. The information about the first FEC encoding includes information of a used FEC code, such as FEC 1 code ID 841, a length of the sub block, such as Sub-Block Length 842, a length of the first parity block, such as Parity 1 Block Length 843, identification information of a source flow, such as Source Flow ID=0x0000 844, identification information of the first parity flow, such as Parity 1 Flow ID=0x0002 845, and other similar information.

The information about the second FEC encoding includes information of a used FEC code, such as FEC 2 code ID 846, a length of the source block or partial source block, such as (Partial) Source Block Length 847, a length of the second parity block, such as Parity 2 Block Length 848, identification information of a source block or partial source flow, such as (Partial) Source Flow ID=0x0001 849, identification information of the second parity flow, such as Parity 2 Flow ID=0x0003 850, and other similar information. In a case having the (Partial) Source Block Length 847, Sub Block length 842, and Parity 1 Block length 843 fields in fixed sizes, out-band signaling for transmission in the FEC control packet may be applied. In contrast, in case of having AL-FEC in a variable size, in-band signaling for transmission in FEC packets may be applied.

FIG. 9 is an exemplary structure of a source packet that makes up the source part of the sub coded block for transferring the coded signal information using in-band signaling, according to an exemplary embodiment of the present invention.

Referring to FIG. 9, a source packet 910 is generated by AL-FEC encoding of a source payload 920 in a form of MMT packet. In other words, the source packet 910 is an MMT packet resulting from application of the AL-FEC encoding in which each source payload 920, i.e. MMT packet, is FEC encoded and then a field for in-band signaling is added thereto. The field for in-band signaling has the coded signal information recorded. Each source payload 920 that makes up the source block is configured by combining an MMT header 940 and an MMP payload 950. As described above, in case of using the in-band signaling, the coded signal information in the source packet is provided in a field 930 for in-band signaling and the MMT header 940 added to the FEC coded source payload.

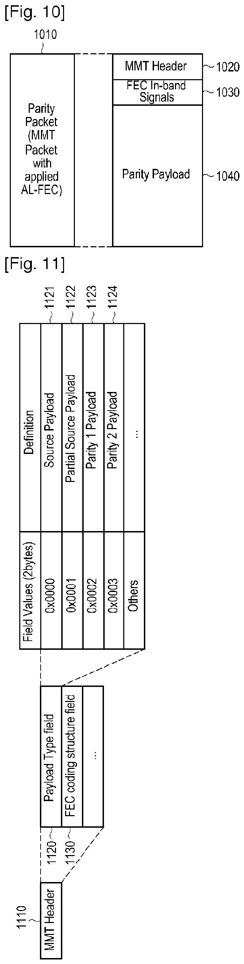

FIG. 10 is an exemplary structure of a parity packet that makes up the parity part of the sub coded block for transferring the coded signal information using in-band signaling, according to an exemplary embodiment of the present invention.

Referring to FIG. 10, in case the source payload that makes up the source block is an MMT packet, one or more parity payloads 1040 generated by FEC encoding of the source payload are included in a single parity packet 1010. That is, the parity packet 1010 is an MMT packet having an MMT header 1020 and a field 1030 for in-band signaling, such as FEC In-band Signals, in addition to one or more parity payloads 1040. The parity packet 1010 is for the parity payload with AL-FEC encoding applied. As described above, in case of using the in-band signaling, the coded signal information in the parity packet is provided in the MMT header 1020 and the field 1030 for in-band signaling added to the FEC coded parity payload 1040.

FIG. 11 is a structure of the MMT header of the MMT packet that corresponds to the source packet of FIG. 9 or the parity packet of FIG. 10, according to an exemplary embodiment of the present invention.

Referring to FIG. 11, the structure of an MMT header 1110 shown in FIG. 11 assumes that the source payload is an MMT packet. The MMT header 1110 includes a payload type field 1120 and an FEC coding structure field 1130. The FEC coding structure field 1130 is equal to the FEC coding structure 814 that makes up the FEC control packet as shown in FIG. 8.

The payload type field 1120 includes a flag to define a type of the payload of the MMT packet. For example, the type of the payload may be classified into a source payload 1121, a partial source payload 1122, a first parity payload 1123, and a second parity payload 1124. In this case, the flag of the payload type field 1120 has a value to define each of the four types of payloads. For example, the flag for the source payload 1121 has a value of '0x0000', the flag for the partial source payload 1122 has a value of '0x0001', the flag for the first parity payload 1123 has a value of '0x0002', and the flag for the second parity payload 1124 has a value of '0x0003'. Thus, the flag enables recognition of a type of the payload that makes up the MMT packet.

For example, in a case where a value of the FEC coding structure field 1130 indicates a partial two-stage FEC coding structure and the flag of the payload type field 1120 has a value 0x0000 indicating the source payload 1121, then it may be recognized that the payload of the MMT packet is the source payload except for the partial source payload among source payloads in the source block. However, the sub block may include both the source payload and the partial source payload. In another case, if a value of the FEC coding structure field 1130 indicates a partial two-stage FEC coding structure and the flag of the payload type field 1120 has a value 0x0001 indicating the partial source payload 1122, then it may be recognized that the payload of the MMT packet is the partial source payload among source payloads in the source block.

In yet another case using the partial FEC encoding, the flag of the payload type field 1120 in the header of the parity packet that is generated from the sub block and makes up the first parity part is set to have a value of '0x0002'. The value of the flag '0x0002' implies that the payload of the MMT packet is the first parity payload 1123 generated by the first FEC encoding of the source payload in the source block.

In yet another case of using the partial FEC encoding, the flag of the payload type field 1120 in the header of the parity packet that is generated from the partial source payload in the sub block and makes up the second parity part is set to have a value of '0x0003'. The value of the flag '0x0003' implies that the payload of the MMT packet is the second parity payload 1124 generated by the second FEC encoding of the partial source payload in the source block. On the other hand, it is suitable for the MMT header of FIG. 11 to be applied to a case in which the coding structure varies dynamically. For a case that the coding structure varies infrequently, the use of the FEC control packet may be more suitable.

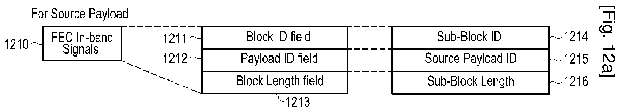

FIGs. 12A to 12D show a structure of FEC In-band signals 930, 1030 of the MMT packet that corresponds to the source packet of FIG. 9 or the parity packet of FIG. 10, according to an exemplary embodiment of the present invention.

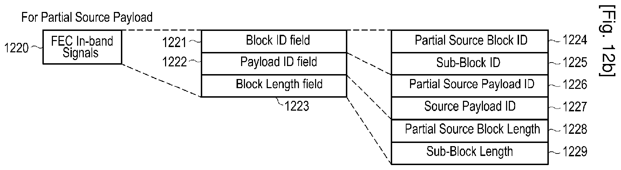

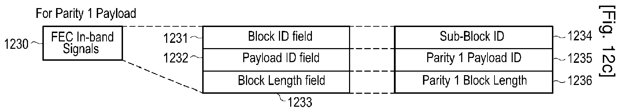

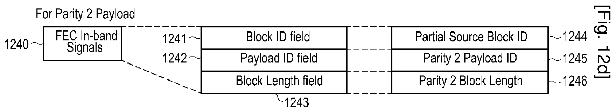

Referring to FIGs. 12A to 12D, a structure of FEC in-band signals 1210, 1220, 1230, 1240, as shown in FIGs. 12A to 12D assumes that the source payload is an MMT packet. The structure of the FEC in-band signals 1210, 1220, 1230, 1240 may be separately defined by payload types of the MMT packet. For example, FIG. 12A is a structure of the FEC in-band signal 1210 in a case where the payload of the MMT packet is the source payload, and FIG. 12B is a structure of the FEC in-band signal 1220 in a case where the payload of the MMT packet is the partial source payload. FIG. 12C is a structure of the FEC in-band signal 1230 in a case where the payload of the MMT packet is the first parity payload, and FIG. 12D is a structure of the FEC in-band signal 1240 in a case where the payload of the MMT packet is the second parity payload.

Each of the FEC in-band signals shown in FIGs. 12A to 12D have a Block ID field 1211, 1221, 1231, 1241, a Payload ID field 1212, 1222, 1232, 1242, and a Block Length field 1213, 1223, 1233, 1243, respectively. Each of the Block ID fields 1211, 1221, 1231, 1241 has information for identifying a block area the corresponding payload belongs to. For example, the Block ID fields 1211, 1221, 1231, 1241 may have a Sub-Block ID 1214, 1225, 1234, and/or a Partial Source Block ID 1224, 1244. That is, in the FEC In-band Signals 1210 of the source packet including the source payload, the Block ID field 1211 includes the Sub-Block ID 1214, and in the FEC In-band Signals 1220 of the source packet including the partial source payload, the Block ID field 1221 includes the Partial Source Block ID 1224 and the Sub-Block ID 1225.

In the FEC In-band Signals 1230 of the parity packet including the first parity payload, the Block ID field 1231 includes the Sub-Block ID 1234, and in the FEC In-band Signals 1240 of the parity packet including the second parity payload, the Block ID field 1241 includes the Partial Source Block ID 1244. The Sub-Block ID 1214, 1225, 1234 each include identification information for distinguishing between sub blocks. Thus, the Sub-Block ID 1214, 1225, 1234 is set to the same value as an ID of the parity block generated from the sub block, which means that the sub block and the parity block are configured in a single FEC block. The same is the case for the Partial Source Block ID 1224, 1244. That is, the Sub-Block ID 1214, 1225, 1234 and the Partial Source Block Id 1224, 1244 correspond to the FEC Block ID.

The Payload ID field 1212, 1222, 1232, 1242 has information about an order of each payload in the FEC Block. For example, the Payload ID field 1212, 1222, 1232, 1242 has a Source Payload ID 1215, 1227, and/or a Partial Source Payload ID 1226 or a Parity 1 Payload ID 1235 or a Parity 2 Payload ID 1235. That is, in the FEC In-band Signals 1210 of the source packet including the source payload, the payload ID field 1212 includes the Source Payload ID 1215; and in the FEC In-band Signals 1220 of the source packet including the partial source payload, the Payload ID field 1222 includes the Partial Source Payload ID 1226 and the Source Payload ID 1227.

In the FEC In-band Signals 1230 of the parity packet including the first parity payload, the Payload ID field 1232 includes the Parity 1 Payload ID 1235, and in the FEC In-band Signals 1240 of the parity packet including the second parity payload, the Payload ID field 1242 includes the Parity 2 Payload ID 1245.

The Source Payload ID 1215, 1227 is information indicating how many source payloads are in the sub block, i.e. are in the place of the corresponding source payload from among other source payloads, and the Partial Source Payload ID 1226 is information indicating how many source payloads are in the partial source block. The Parity 1 Payload ID 1235 is information indicating how many payloads are in the first parity block, and the Parity 2 Payload ID 1245 is information indicating how many payloads are in the second parity block.

The Block Length field 1213, 1223, 1233, 1243 has information about each block length. In an example, the Block Length field 1213, 1223, 1233, 1243 indicates, for source payloads included in a sub block, how many source payloads make up the sub block, for a partial source block, how many partial source payloads make up the partial source block, for a first parity block, how many first parity payloads make up the first parity block, and for a second parity block, how many second parity payloads make up the second parity block. That is, in the FEC In-band Signals 1210 of the source packet including the source payload, the Block Length field 1213 includes the Sub-Block Length 1216, and in the FEC In-band Signals 1220 of the source packet including the partial source payload, the Block Length field 1223 includes the Partial Source Block length 1228 and the Sub-Block length 1229.

In the FEC In-band Signals 1230 of the parity packet including the first parity payload, the Block Length field 1233 includes the Parity 1 Block Length 1236, and in the FEC In-band Signals 1240 of the parity packet including the second parity payload, the Block Length field 1243 includes the Parity 2 Block Length 1246. Meanwhile, the FEC In-Band Signaling scheme may be largely classified into a scheme based on the sequence number and a scheme based on the payload ID.

First, in the scheme based on the sequence number, a sequence number is assigned to an entire source payload, including a partial source payload, protected by the first FEC encoding in an incrementing manner. The sequence number assigned to the entire source payload may be used as the Source Payload ID. A sequence number is assigned to a partial source payload protected by the second FEC encoding in an incrementing manner. The sequence number assigned to the partial source payload may be used as the Partial Source Payload ID. In this case, a Block ID may be set to be the sequence number assigned to the first packet in each FEC block. The Block ID is set for all packets in the FEC block in common.

Next, in case where the scheme is based on the Payload ID, the Block ID is set to distinguish the FEC block in FIGs. 12A to 12D. For example, the Block ID for all packets of the first FEC block is set to '0', and the Block ID for all packets of the second FEC block is set to '1'. That is, the Block ID is set based on the order of the FEC blocks. The payload ID is given for each source payload in the sub block, or partial sub block, as 0, 1, 2,..., or K-1, wherein K is the number of source payloads in the sub block, and for each parity payload in the parity block as 0, 1, 2,..., or P-1, wherein P is the number of parity payloads in the parity block, or K, K+1, ..., K + P - 1.

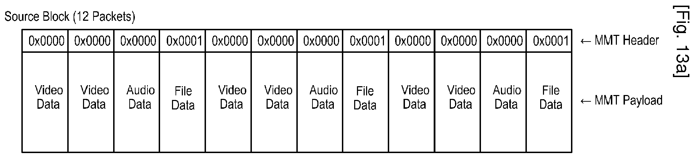

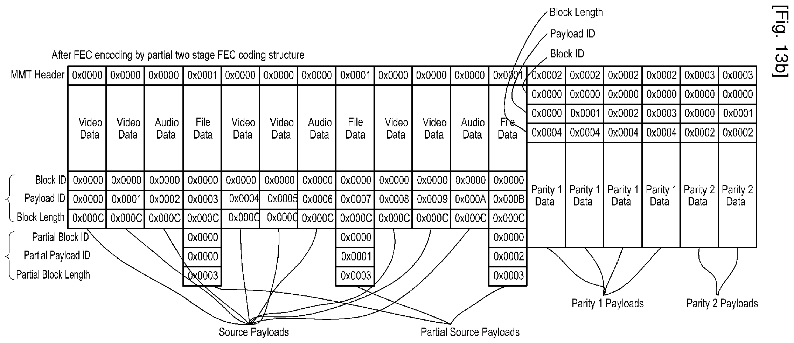

FIGs. 13A and 13B show implementations of the partial two-stage FEC encoding scheme with in-band signaling, according to an exemplary embodiment of the present invention.

Referring to FIGs. 13A and 13B, in case where the source payload is an MMT packet, FIG. 13A shows a structure of the source block and FIG. 13B shows a structure of the source coded block for in-band signaling. An example of a single source block including 12 packets corresponding to 6 pieces of video data, 3 pieces of audio data, and 3 pieces of file data, as is shown in FIG. 13A. Each of the 12 packets consists of an MMT header and an MMT payload. Furthermore, assume that the single source block is divided into a single sub block. That is, assume that the source block and the sub block includes the same data segments.

The first FEC encoding with the first FEC code is performed on 12 data segments that make up the source block, i.e. 12 packets. The first FEC encoding generates 12 source packets and 4 base parity packets. Each of 12 source packets has a source payload, i.e. an MMT Packet, and FEC in-band signals. The source payload consists of an MMT payload and an MMT header. Each of the 4 base parity packets has a parity payload, FEC in-band signals, and an MMT header.

The second FEC encoding with the second FEC code is performed on partial source block, such as 3 File packets, from among 12 data segments, i.e. the 12 packets that make up the source block. The second FEC encoding generates 2 extended parity packets. Each of the 2 extended parity packets has a parity payload, FEC in-band signals, and an MMT header. The MMT headers of the 12 source packets, the 4 base parity packets, and the 2 extended parity packets have flags indicating which type of data makes up the payload of the corresponding packet.

For example, the MMT header of the source packet having a source payload that corresponds to video and audio data has the flag set to be '0x0000', and the MMT header of the source packet having a source payload that corresponds to file data has the flag set to be '0x0001'. The MMT headers of the 4 base parity packets have the flag set to be '0x0002', and the MMT headers of the 2 extended parity packets have the flag set to be '0x0003'.

FEC in-band signals that make up the 12 source packets, 4 base parity packets, and 2 extended parity packets may be set according to the flag value set in the MMT header. For example, independently of the flag value set in the MMT header in the 12 source packets, 4 base parity packets, and 2 extended parity packets, the FEC in-band signals of the 12 source packets, 4 base parity packets, and 2 extended parity packets have a 'Block ID', a 'Payload ID', and a 'Block Length' in common. However, the FEC in-band signals of a source packet having a flag set to be '0x0001' in the MMT header, i.e., a partial source packet among the 12 source packets additionally include a 'Partial Block ID', a 'Partial Payload ID', and a 'Partial Block Length'. That is, in case of the partial source payload, the FEC in-band signals include the 'Partial Block ID', 'Partial Payload ID', and 'Partial Block Length'.

The coded signal information needs to be provided to the decoding apparatus based on a predetermined transmission scheme. For example, the transmission scheme may be either an out-band signaling based transmission scheme or an in-band signaling based transmission scheme.

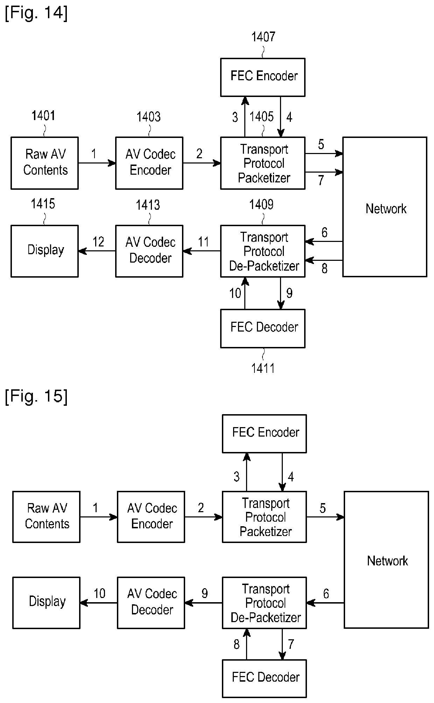

FIG. 14 shows a block diagram of an apparatus for transmitting the coded signal information using the out-band signaling, according to an exemplary embodiment of the present invention.

Referring to FIG. 14, a data steam 1 corresponding to some raw AV contents 1401 stored in advance or generated is provided to an AV codec encoder 1403. An example of the data stream 1 may be a raw AV stream. The AV codec encoder 1403 compresses the data stream 1 with audio codec and video codec encoders and provides the compressed data stream 2 to a transport protocol packetizer 1405.

The transport protocol packetizer 1405 configures a source block 3 to be subject to FEC encoding based on the compressed data stream 2, and provides the source block 3 to an FEC encoder 1407. At this time, an encoding structure and/or encoding configuration related information for FEC encoding may be provided together. The FEC encoder 1407 performs first FEC encoding and second FEC encoding on the source block based on the encoding structure and/or the encoding configuration related information. The FEC encoder 1407 provides the transport protocol packetizer 1405 with a source coded block 4 generated by the first FEC encoding and the second FEC encoding. The transport protocol packetizer 1405 configures an FEC packet 7 by adding a header to the source coded block 4 provided by the FEC encoder 1407, and transmits the FEC packet 7 over a network. The transport protocol packetizer 1405 also configures the coded signal information, i.e. the FEC control information corresponding to the FEC packet 7, to be transmitted over the network.

The transport protocol packetizer 1405 may generate a coded signal packet 5, i.e., an FEC control packet 5 according to the coded signal information and transmit the coded signal packet 5 ahead of transmission of the FEC packet 7 over the network for a decoding apparatus to refer to the coded signal information 5, i.e. the FEC control information 5 in decoding the received FEC packet 7. For example, the decoding apparatus may obtain FEC structure and/or FEC coding configuration related information from the coded signal information 5, i.e., the FEC control information 5.

A transport protocol de-packetizer 1409 receives an FEC control packet 6, and prepares for decoding of a source coded packet 8, which is to be received later, based on the coded signal information obtained from the received FEC control packet 6. Receiving the source coded packet 8, the transport protocol de-packetizer 1409 obtains from the source coded packet 8 a source coded block 9 based on the coded signal information obtained in advance and provides the source coded block 9 to an FEC decoder 1411. The FEC decoder 1411 obtains data segments per sub block by performing decoding on the source coded block 9 received from the transport protocol de-packetizer 1409 based on the coded signal information obtained in advance. If there is a data segment missing, the missed data segment is recovered.

The FEC encoder 1411 provides the transport protocol de-packetizer 1409 with a source block 10 obtained from decoding of the source coded block 9. The transport protocol de-packetizer 1409 configures a compressed data stream 11 from the source block 10 provided from the FEC Decoder 1411, and provides the compressed data stream 11 to an AV codec decoder 1413. The AV codec decoder 1413 extracts a video and audio data stream 12 corresponding to AV content from the compressed data stream 11 with audio codec and video codec decoders, and provides the video and audio data stream 12 to a display 1415.

FIG. 15 shows a block diagram of an apparatus for transmitting the coded signal information using in-band signaling, according to an exemplary embodiment of the present invention.

Referring to FIG. 15, a processing procedure in the apparatus of FIG. 15 is similar to the foregoing procedure of FIG. 14. However, the processing procedure of FIG. 15 includes no operations corresponding to steps 5 and 6 in FIG. 14. Due to the omission of reference numbers 5 and 6, reference numbers 7 to 12 of FIG. 14 correspond to reference numbers 5 to 10 of FIG. 15.

For reference numbers 5 and 6 of FIG. 15, the FEC control information, i.e. the coded signal information about a corresponding source packet or parity packet, is forwarded in the header of the source packet or parity packet in the source coded block, in in reference numbers 5 and 6 of FIG. 15. In FIGs. 14 and 15, the AV content is assumed for description, but the present invention is not limited thereto, and any similar and/or suitable type of content may be used. For example, the same is the case for the hybrid content delivery service by which AV data and file data are transmitted together. In the case of the hybrid content delivery service, the source block includes data segments corresponding to the file data as well as data segments corresponding to the AV data.

According to the above described exemplary embodiments, efficient protection of the source block is possible by applying selective FEC encoding for different kinds of data having different QoS requirements for a broadcasting service.

While exemplary embodiment of the present invention has been particularly shown and described with reference to embodiments thereof, it will be understood by those of ordinary skill in the art that various changes in form and details may be made therein without departing from the scope of the present invention as defined by the following claims.

For example, the foregoing exemplary embodiment of the present invention assumes the case the source payload has the MMT payload format. That is, in the case the source payload has the MMT payload format, the method of configuring the source block was described. However, the exemplary embodiment of the present invention is equally applied in a case the source payload has an MMT packet format. Here, the MMT packet format has the MMT payload format plus the MMT header. In this case, it is desirable for the MMT payload format to be replaced by the MMT packet format, and for information, such as asset ID or I-frame indicator to be stored in the MMT header.

While the invention has been shown and described with reference to certain exemplary embodiments thereof, it will be understood by those skilled in the art that various changes in form and details may be made therein without departing from the scope of the invention as defined by the appended claims

## Claims

1. A method of encoding a source block including layered media data with a base layer and an enhanced layer, the method comprising:
dividing the source block into a predetermined number M of sub blocks, wherein each sub-block contains segments and the segments contain data from the base layer and from the enhanced layer;
generating a predetermined number M of sub coded blocks by performing first Forward Error Correction, FEC, encoding on each of the predetermined number M of sub blocks wherein each sub coded block includes a source part and a parity part PI;
generating an extended parity part corresponding to the source block by performing second FEC encoding on segments that make up the source block, wherein full two stage FEC encoding is performed by encoding the entire source block or partial two stage FEC encoding is performed by encoding the segments that make up the source block and which contain data from the base layer; and
configuring a source coded block by combining said M sub coded blocks and the extended parity part; and
transmitting an FEC control packet that corresponds to the source coded block,
wherein the FEC control packet includes an FEC control packet header (820) and a part including an FEC coding structure field (830) and an FEC configuration info field (840),
wherein the FEC control packet header includes first information identifying that it is an FEC control packet, and the FEC coding structure field (830) includes second information that identifies which encoding scheme was used for the source coded packet being transmitted,
wherein the second information is for distinguishing cases where the encoding scheme is a full two stage FEC encoding scheme which arises when a segment is made up by multiplexing data from the base layer and from the enhanced layer and cases where the encoding scheme is a partial two stage FEC encoding scheme which arises when each segment contains either data from the base layer or from the enhanced layer.

2. The method of claim 1, wherein the transmitting of the coded signal information using in-band signaling comprises recording the coded signal information in an MPEG Media Transport, MMT, header and an in-band signal field, wherein the MMT header is a header to be combined to the segments that make up the source block, the M of sub coded blocks and the extended parity parts, and wherein the in-band signal field is a field to be combined to the segments that make up the source block, the M of sub coded blocks and the extended parity parts for recording the coded signal information.

3. The method of claim 2, wherein the coded signal information recorded in the in-band signal field comprises block identification information, part identification information, and block length information.

4. The method of claim 3, wherein the block identification information comprises at least one of sub block identification information and partial source block identification information, and wherein the part identification information comprises at least one of source part identification information, partial source part identification information, sub coded block identification information, and extended parity part identification information, and wherein the block length information comprises at least one of sub block length information, partial source block length information, sub coded block length information, and extended block length information.

5. The method of claim 4, wherein the coded signal information recorded in the FEC configuration information field comprises first FEC code identification information, sub block length information, sub coded block length information, source flow identification information, sub coded block flow identification information, second FEC code identification information, source block length information or partial source block length information, extended parity block length information, source flow identification information or partial source flow identification information, and extended parity flow identification information.

6. The method of claim 2, wherein the MMT header comprises flag information for identifying a part to be encoded with the second FEC code.

7. A coding apparatus for encoding a source block layered media data with a base layer and an enhanced layer, the coding apparatus comprising:
an encoder for generating a predetermined number M of sub coded blocks generated by dividing the source block into a predetermined number M of sub blocks and by performing first Forward Error Correction, FEC, encoding on each of the predetermined number M of sub blocks, wherein each sub-block contains segments and the segments contain data from the base layer and from the enhanced layer and each sub coded block includes a source part and a parity part P1, and for generating an extended parity parts corresponding to the source block by performing second FEC encoding on segments that make up the source block, wherein full two stage FEC encoding is performed by encoding the entire source block or partial two stage FEC encoding is performed by encoding the segments that make up the source block and which contain data from the base layer; and
a packetizer for configuring a source coded block by combining said M of sub blocks, and the extended parity parts,
wherein the packetizer is configured for transmitting an FEC control packet that corresponds to the source coded block,
wherein the FEC control packet includes an FEC control packet header (820) and a part including an FEC coding structure field (830) and an FEC configuration info field (840), wherein the FEC control packet header includes first information identifying that it is an FEC control packet, and the FEC coding structure field (830) includes second information that identifies which encoding scheme was used for the source coded packet being transmitted,
wherein the second information is for distinguishing cases where the encoding scheme is a full two stage FEC encoding scheme which arises when a data segment is made up by multiplexing data from the base layer and from the enhanced layer and cases where the encoding scheme is a partial two stage FEC encoding scheme which arises when each segment contains either data from the base layer or from the enhanced layer.

8. The encoding apparatus of claim 7, wherein the packetizer, in case of transmitting the coded signal information using in-band signaling, records the coded signal information in an MPEG Media Transport, MMT, header and an in-band signal field, wherein the MMT header is a header to be combined to the segments that make up the source block, the M of sub coded blacks and the extended parity parts, and wherein the in-band signal field is a field to be combined to the segments that make up the source block, the M of sub coded blocks and the extended parity parts for recording the coded signal information.

9. The encoding apparatus of claim 8, wherein the coded signal information recorded in the in-band signal field comprises block identification information, part identification information, and block length information.

10. The encoding apparatus of claim 9, wherein the block identification information comprises at least one of sub block identification information and partial source block identification information, and wherein the part identification information comprises at least one of source part identification information, partial source part identification information, sub coded block identification information, and extended parity part identification information, and wherein the block length information comprises at least one of sub block length information, partial source block length information, sub coded block length information, and extended block length information.

11. The encoding apparatus of claim 10, wherein the coded signal information recorded in the FEC configuration information field comprises first FEC code identification information, sub block length information, sub coded block length information, source flow identification information, sub coded block flow identification information, second FEC code identification information, source block length information or partial source block length information, extended parity block length information, source flow identification information or partial source flow identification information, and extended parity flow identification information.

12. The encoding apparatus of claim 8, wherein the MMT header comprises flag information for identifying a part to be encoded with the second FEC code.

## Patentansprüche

1. Verfahren zum Codieren eines Quellblocks einschließlich geschichteter Mediendaten mit einer Basisschicht und einer erweiterten Schicht, wobei das Verfahren Folgendes umfasst:
Teilen des Quellblocks in eine vorbestimmte Anzahl M von Unterblöcken, wobei jeder Unterblock Segmente enthält und die Segmente Daten aus der Basisschicht und aus der erweiterten Schicht enthalten;
Erzeugen einer vorbestimmten Anzahl M von untercodierten Blöcken durch Ausführen einer ersten Vorwärtsfehlerkorrektur(FEC)-Codierung auf jedem der vorbestimmten Anzahl M von Unterblöcken, wobei jeder untercodierte Block einen Quellteil und einen Paritätsteil P1 enthält;
Erzeugen eines erweiterten Paritätsteils entsprechend dem Quellblock durch Ausführen einer zweiten FEC-Codierung an Segmenten, die den Quellblock bilden, wobei eine vollständige zweistufige FEC-Codierung durch Codieren des gesamten Quellblocks ausgeführt wird oder eine partielle zweistufige FEC-Codierung durch Codieren der Segmente ausgeführt wird, die den Quellblock bilden und die Daten aus der Basisschicht enthalten; und
Konfigurieren eines quellcodierten Blocks durch Kombinieren der besagten M untercodierten Blöcke und des erweiterten Paritätsteils; und
Übertragen eines FEC-Steuerpakets, das dem quellcodierten Block entspricht,
wobei das FEC-Steuerpaket einen FEC-Steuerpaket-Header (820) und einen Teil enthält, der ein FEC-Codierungsstrukturfeld (830) und ein FEC-Konfigurationsinfofeld (840) enthält,
wobei der FEC-Steuerpaket-Header erste Informationen enthält, die identifizieren, dass es ein FEC-Steuerpaket ist, und das FEC-Codierungsstrukturfeld (830) zweite Informationen enthält, die identifizieren, welches Codierungsschema für das übertragene quellcodierte Paket verwendet wurde,
wobei die zweiten Informationen zum Unterscheiden von Fällen dienen, in denen das Codierungsschema ein vollständiges zweistufiges FEC-Codierungsschema ist, das entsteht, wenn ein Segment durch Multiplexieren von Daten aus der Basisschicht und aus der erweiterten Schicht gebildet wird, und von Fällen, in denen das Codierungsschema ein partielles zweistufiges FEC-Codierungsschema ist, das entsteht, wenn jedes Segment entweder Daten aus der Basisschicht oder aus der erweiterten Schicht enthält.

2. Verfahren nach Anspruch 1, wobei das Übertragen der codierten Signalinformationen unter Verwenden von In-Band-Signalisierung das Aufzeichnen der codierten Signalinformationen in einem MPEG-Medientransport(MMT)-Header und einem In-Band-Signalfeld umfasst, wobei der MMT-Header ein Header ist, der mit den Segmenten kombiniert werden soll, die den Quellblock, die M untercodierten Blöcke und die erweiterten Paritätsteile bilden, und wobei das In-Band-Signalfeld ein Feld ist, das mit den Segmenten kombiniert werden soll, die den Quellblock, die M untercodierten Blöcke und die erweiterten Paritätsteile zum Aufzeichnen der codierten Signalinformationen bilden.

3. Verfahren nach Anspruch 2, wobei die in dem In-Band-Signalfeld aufgezeichneten codierten Signalinformationen Blockidentifikationsinformationen, Teilidentifikationsinformationen und Blocklängeninformationen umfassen.

4. Verfahren nach Anspruch 3, wobei die Blockidentifikationsinformationen Unterblockidentifikationsinformationen und/oder partielle Quellblockidentifikationsinformationen umfassen, und wobei die Teilidentifikationsinformationen Quellteilidentifikationsinformationen, partielle Quellteilidentifikationsinformationen, untercodierte Blockidentifikationsinformationen und/oder erweiterte Paritätsteilidentifikationsinformationen umfassen, und wobei die Blocklängeninformationen Unterblocklängeninformationen, partielle Quellblocklängeninformationen, untercodierte Blocklängeninformationen und/oder erweiterte Blocklängeninformationen umfassen.

5. Verfahren nach Anspruch 4, wobei die in dem FEC-Konfigurationsinformationsfeld aufgezeichneten codierten Signalinformationen erste FEC-Code-Identifikationsinformationen, Unterblocklängeninformationen, untercodierte Blocklängeninformationen, Quellflussidentifikationsinformationen, untercodierte Blockflussidentifikationsinformationen, zweite FEC-Code-Identifikationsinformationen, Quellblocklängeninformationen oder partielle Quellblocklängeninformationen, erweiterte Paritätsblocklängeninformationen, Quellflussidentifikationsinformationen oder partielle Quellflussidentifikationsinformationen und erweiterte Paritätsflussidentifikationsinformationen umfassen.

6. Verfahren nach Anspruch 2, wobei der MMT-Header Flag-Informationen zum Identifizieren eines mit dem zweiten FEC-Code zu codierenden Teils umfasst.

7. Codierungsvorrichtung zum Codieren von geschichteten Quellblock-Mediendaten mit einer Basisschicht und einer erweiterten Schicht, wobei die Codierungsvorrichtung Folgendes umfasst:
einen Encoder zum Erzeugen einer vorbestimmten Anzahl M von untercodierten Blöcken, die durch Unterteilen des Quellblocks in eine vorbestimmte Anzahl M von Unterblöcken und durch Ausführen einer ersten Vorwärtsfehlerkorrektur(FEC)-Codierung an jedem der vorbestimmten Anzahl M von Unterblöcken erzeugt werden, wobei jeder Unterblock Segmente enthält und die Segmente Daten aus der Basisschicht und aus der erweiterten Schicht enthalten und jeder untercodierte Block einen Quellteil und einen Paritätsteil P1 enthält, und zum Erzeugen erweiterter Paritätsteile entsprechend dem Quellblock durch Ausführen einer zweiten FEC-Codierung an Segmenten, die den Quellblock bilden, wobei die vollständige zweistufige FEC-Codierung durch Codieren des gesamten Quellblocks ausgeführt wird oder die partielle zweistufige FEC-Codierung durch Codieren der Segmente ausgeführt wird, die den Quellblock bilden und Daten aus der Basisschicht enthalten; und
einen Paketierer zum Konfigurieren eines quellcodierten Blocks durch Kombinieren der besagten M Unterblöcke und der erweiterten Paritätsteile,
wobei der Paketierer zum Übertragen eines FEC-Steuerpakets konfiguriert ist, das dem quellcodierten Block entspricht,
wobei das FEC-Steuerpaket einen FEC-Steuerpaket-Header (820) und einen Teil einschließlich eines FEC-Codierungsstrukturfeldes (830) und eines FEC-Konfigurationsinfofeldes (840) enthält,
wobei der FEC-Steuerpaket-Header erste Informationen enthält, die identifizieren, dass es ein FEC-Steuerpaket ist, und das FEC-Codierungsstrukturfeld (830) zweite Informationen enthält, die identifizieren, welches Codierungsschema für das übertragene quellencodierte Paket verwendet wurde,
wobei die zweiten Informationen zum Unterscheiden von Fällen dienen, in denen das Codierungsschema ein vollständiges zweistufiges FEC-Codierungsschema ist, das entsteht, wenn ein Datensegment durch Multiplexieren von Daten aus der Basisschicht und aus der erweiterten Schicht gebildet wird, und von Fällen, in denen das Codierungsschema ein partielles zweistufiges FEC-Codierungsschema ist, das entsteht, wenn jedes Segment entweder Daten aus der Basisschicht oder aus der erweiterten Schicht enthält.

8. Codierungsvorrichtung nach Anspruch 7, wobei der Paketierer im Falle des Übertragens der codierten Signalinformationen unter Verwenden von In-Band-Signalisierung die codierten Signalinformationen in einem MPEG-Medientransport(MMT)-Header und einem In-Band-Signalfeld aufzeichnet, wobei der MMT-Header ein Header ist, der mit den Segmenten kombiniert werden soll, die den Quellblock, die M untercodierten Blöcke und die erweiterten Paritätsteile bilden, und wobei das In-Band-Signalfeld ein Feld ist, das mit den Segmenten kombiniert werden soll, die den Quellblock, die M untercodierten Blöcke und die erweiterten Paritätsteile zum Aufzeichnen der codierten Signalinformationen bilden.

9. Codierungsvorrichtung nach Anspruch 8, wobei die in dem In-Band-Signalfeld aufgezeichneten codierten Signalinformationen Blockidentifikationsinformationen, Teilidentifikationsinformationen und Blocklängeninformationen umfassen.

10. Codierungsvorrichtung nach Anspruch 9, wobei die Blockidentifikationsinformationen Unterblockidentifikationsinformationen und/oder partielle Quellblockidentifikationsinformationen umfassen, und wobei die Teilidentifikationsinformationen Quellteilidentifikationsinformationen, partielle Quellteilidentifikationsinformationen, untercodierte Blockidentifikationsinformationen und/oder erweiterte Paritätsteilidentifikationsinformationen umfassen, und wobei die Blocklängeninformationen Unterblocklängeninformationen, partielle Quellblocklängeninformationen, untercodierte Blocklängeninformationen und/oder erweiterte Blocklängeninformationen umfassen.

11. Codierungsvorrichtung nach Anspruch 10, wobei die in dem FEC-Konfigurationsinformationsfeld aufgezeichneten codierten Signalinformationen erste FEC-Code-Identifikationsinformationen, Unterblocklängeninformationen, untercodierte Blocklängeninformationen, Quellflussidentifikationsinformationen, untercodierte Blockflussidentifikationsinformationen, zweite FEC-Code-Identifikationsinformationen, Quellblocklängeninformationen oder partielle Quellblocklängeninformationen, erweiterte Paritätsblocklängeninformationen, Quellflussidentifikationsinformationen oder partielle Quellflussidentifikationsinformationen und erweiterte Paritätsflussidentifikationsinformationen umfassen.

12. Codierungsvorrichtung nach Anspruch 8, wobei der MMT-Header Flag-Informationen zum Identifizieren eines mit dem zweiten FEC-Code zu codierenden Teils umfasst.

## Revendications

1. Procédé de codage d'un bloc source comprenant des données multimédias multicouches avec une couche de base et une couche améliorée, le procédé comprenant
diviser le bloc source en un nombre prédéterminé M de sous-blocs, où chaque sous-bloc contient des segments et les segments contiennent des données provenant de la couche de base et de la couche améliorée ;
générer un nombre prédéterminé M de sous-blocs codés en effectuant un premier codage de correction d'erreur directe, FEC, sur chacun du nombre prédéterminé M de sous-blocs où chaque sous-bloc codé comprend une partie source et une partie de parité P1 ;
générer une partie de parité étendue correspondant au bloc source en effectuant un deuxième codage FEC sur des segments qui forment le bloc source, où un codage FEC à deux étages complet est effectué en codant le bloc source entier ou un codage FEC à deux étages partiel est effectué en codant les segments qui forment le bloc source et qui contiennent des données de la couche de base ; et
configurer un bloc codé source en combinant lesdits M sous-blocs codés et la partie de parité étendue ; et
transmettre un paquet de contrôle FEC qui correspond au bloc codé source,
où le paquet de contrôle FEC comprend un en-tête de paquet de contrôle FEC (820) et une partie comprenant un champ de structure de codage FEC (830) et un champ d'informations de configuration FEC (840),
où l'en-tête de paquet de contrôle FEC comprend des premières informations identifiant qu'il s'agit d'un paquet de contrôle FEC, et le champ de structure de codage FEC (830) comprend des deuxièmes informations identifiant quel schéma de codage a été utilisé pour le paquet codé source en cours de transmission,
où les deuxièmes informations sont destinées à distinguer des cas dans lesquels le schéma de codage est un schéma de codage FEC à deux étages complet qui survient lorsqu'un segment est formé en multiplexant des données provenant de la couche de base et de la couche améliorée et des cas dans lesquels le schéma de codage est un schéma de codage FEC à deux étages partiel qui survient lorsque chaque segment contient des données provenant soit de la couche de base soit de la couche améliorée.

2. Procédé selon la revendication 1, où la transmission des informations de signal codées en utilisant une signalisation intrabande comprend l'enregistrement des informations de signal codées dans un en-tête de transport multimédia de MPEG, MMT, et un champ de signal intrabande, où l'en-tête de MMT est un en-tête à être combiné aux segments qui forment le bloc source, le M de sous-blocs codés et les parties de parité étendues, et où le champ de signal intrabande est un champ à être combiné aux segments qui forment le bloc source, le M de sous-blocs codés et les parties de parité étendues pour enregistrer les informations de signal codées.

3. Procédé selon la revendication 2, où les informations de signal codées enregistrées dans le champ de signal intrabande comprennent des informations d'identification de bloc, des informations d'identification de partie et des informations de longueur de bloc.

4. Procédé selon la revendication 3, où les informations d'identification de bloc comprennent au moins l'une parmi des informations d'identification de sous-bloc et des informations d'identification de bloc source partiel, et où les informations d'identification de partie comprennent au moins l'une parmi des informations d'identification de partie source, des informations d'identification de partie source partielle, des informations d'identification de sous-bloc codé, et des informations d'identification de partie de parité étendue, et où les informations de longueur de bloc comprennent au moins l'une parmi des informations de longueur de sous-bloc, des informations de longueur de bloc source partiel, des informations de longueur de sous-bloc codé, et des informations de longueur de bloc étendu.

5. Procédé selon la revendication 4, où les informations de signal codées enregistrées dans le champ d'informations de configuration FEC comprennent des premières informations d'identification de code FEC, des informations de longueur de sous-bloc, des informations de longueur de sous-bloc codé, des informations d'identification de flux source, des informations d'identification de flux de sous-bloc codé, des deuxièmes informations d'identification de code FEC, des informations de longueur de bloc source ou des informations de longueur de bloc source partiel, des informations de longueur de bloc de parité étendu, des informations d'identification de flux source ou des informations d'identification de flux source partiel, et des informations d'identification de flux de parité étendu.

6. Procédé selon la revendication 2, où l'en-tête de MMT comprend des informations de drapeau pour identifier une partie à être codée avec le deuxième code FEC.

7. Appareil de codage pour coder des données multimédias multicouches de bloc source avec une couche de base et une couche améliorée, l'appareil de codage comprenant :
un codeur pour générer un nombre prédéterminé M de sous-blocs codés générés en divisant le bloc source en un nombre prédéterminé M de sous-blocs et en effectuant un premier codage de correction d'erreur directe, FEC, sur chacun du nombre prédéterminé M de sous-blocs, où chaque sous-bloc contient des segments et les segments contiennent des données provenant de la couche de base et de la couche améliorée et chaque sous-bloc codé comprend une partie source et une partie de parité P1, et pour générer une partie de parité étendue correspondant au bloc source en effectuant un deuxième codage FEC sur des segments qui forment le bloc source, où un codage FEC à deux étages complet est effectué en codant le bloc source entier ou un codage FEC à deux étages partiel est effectué en codant les segments qui forment le bloc source et qui contiennent des données de la couche de base ; et
un dispositif de mise en paquets pour configurer un bloc codé source en combinant ledit M de sous-blocs, et les parties de parité étendues,
où le dispositif de mise en paquets est configuré pour transmettre un paquet de contrôle FEC qui correspond au bloc codé source,
où le paquet de contrôle FEC comprend un en-tête de paquet de contrôle FEC (820) et une partie comprenant un champ de structure de codage FEC (830) et un champ d'informations de configuration FEC (840), où l'en-tête de paquet de contrôle FEC comprend des premières informations identifiant qu'il s'agit d'un paquet de contrôle FEC, et le champ de structure de codage FEC (830) comprend des deuxièmes informations identifiant quel schéma de codage a été utilisé pour le paquet codé source en cours de transmission,
où les deuxièmes informations sont destinées à distinguer des cas dans lesquels le schéma de codage est un schéma de codage FEC à deux étages complet qui survient lorsqu'un segment de données est formé en multiplexant des données de la couche de base et de la couche améliorée et des cas dans lesquels le schéma de codage est un schéma de codage FEC à deux étages partiel qui survient lorsque chaque segment contient des données provenant soit de la couche de base soit de la couche améliorée.

8. Appareil de codage selon la revendication 7, où le dispositif de mise en paquets, en cas de transmission des informations de signal codées en utilisant une signalisation intrabande, enregistre les informations de signal codées dans un en-tête de transport multimédia de MPEG, MMT, et un champ de signal intrabande, où l'en-tête de MMT est un en-tête à être combiné aux segments qui forment le bloc source, le M de sous-blocs codés et les parties de parité étendues, et où le champ de signal intrabande est un champ à être combiné aux segments qui forment le bloc source, le M de sous-blocs codés et les parties de parité étendues pour enregistrer les informations de signal codées.

9. Appareil de codage selon la revendication 8, où les informations de signal codées enregistrées dans le champ de signal intrabande comprennent des informations d'identification de bloc, des informations d'identification de partie et des informations de longueur de bloc.

10. Appareil de codage selon la revendication 9, où les informations d'identification de bloc comprennent au moins l'une parmi des informations d'identification de sous-bloc et des informations d'identification de bloc source partiel, et où les informations d'identification de partie comprennent au moins l'une parmi des informations d'identification de partie source, des informations d'identification de partie source partielle, des informations d'identification de sous-bloc codé, et des informations d'identification de partie de parité, et où les informations de longueur de bloc comprennent au moins l'une parmi des informations de longueur de sous-bloc, des informations de longueur de bloc source partiel, des informations de longueur de sous-bloc codé, et des informations de longueur de bloc étendu.

11. Appareil de codage selon la revendication 10, où les informations de signal codées enregistrées dans le champ d'informations de configuration FEC comprennent des premières informations d'identification de code FEC, des informations de longueur de sous-bloc, des informations de longueur de sous-bloc codé, des informations d'identification de flux source, des informations d'identification de flux de sous-bloc codé, des deuxièmes informations d'identification de code FEC, des informations de longueur de bloc source ou des informations de longueur de bloc source partiel, des informations de longueur de bloc de parité étendu, des informations d'identification de flux source ou des informations d'identification de flux source partiel, et des informations d'identification de flux de parité étendu.

12. Appareil de codage selon la revendication 8, où l'en-tête de MMT comprend des informations de drapeau pour identifier une partie à être codée avec le deuxième code FEC.
